# EUROPÄISCHE PATENTSCHRIFT

(11) **EP 0 609 651 B1**
(45) Veröffentlichungstag und Bekanntmachung des Hinweises auf die Patenterteilung: **19.03.1997**
(21) Anmeldenummer: 94100077.0
(22) Anmeldetag: 05.01.1994
(51) Int. Cl.: E06B 3/66, H01L 31/048

(54) **Fassadenelement**
Façade element
Elément de façade

(30) Priorität: 18.01.1993 DE 4301128
(43) Veröffentlichungstag der Anmeldung: 10.08.1994
(73) Patentinhaber: SCHÜCO International KG, D-33609 Bielefeld (DE)
(72) Erfinder:
(74) Vertreter: Loesenbeck, Karl-Otto, Dipl.-Ing.

(56) Entgegenhaltungen:
- CH-A- 575 351
- DE-A- 2 501 923
- DE-U- 8 802 500
- FR-A- 1 264 475
- US-A- 3 760 157
- US-A- 4 306 140
- US-A- 4 542 282

## Beschreibung

Die vorliegende Erfindung betrifft ein Fassadenelement mit einer als Verbundglasscheibe ausgebildeten Außenscheibe und mit einer aus mindestens einer Glasscheibe bestehenden Innenscheibe, die über einen Abstandshalterahmen mit der Außenscheibe verbunden ist, wobei zwischen den Lagen der Außenscheibe im Abstand zueinander angeordnete photovoltarische Elemente angeordnet sind, die über elektrische Leitungen miteinander verbunden sind. Ein in Rede stehendes Fassadenelement ist aus DE-U-90 17 938 bekannt. Die als Verbundglasscheibe ausgebildete Außenscheibe besteht aus zwei die Lagen bildenden Glasscheiben, die in einem geringen Abstand zueinander angeordnet sind, so daß die photovoltarischen Elemente von relativ geringer Dicke dazwischen angeordnet werden können. Die photovoltarischen Elemente sind reihenweise über die Höhe des Fassadenelementes verteilt. Bei den photovoltarischen Elementen wird der lichtelektrische Effekt ausgenutzt um elektrische Energie zu erzeugen. Die Energieführung erfolgt über die elektrischen Leitungen. Zur Isolation sind die photovoltarischen Elemente und die Leitungen in einer Gießharzschicht eingebettet. Das Fassadenelement ist sinngemäß wie eine Isolierglasscheibe zu sehen. Es ist nun notwendig, daß die Leitungen aus dem Fassadenelement herausgeführt werden, um die Energie abzunehmen. Dazu ist das Fassadenelement gemäß dem Stand der Technik mit einer Sammelschiene ausgerüstet, an die die Leitungen angeschlossen sind. Diese Ausführung ist aufwendig, da an die Sammelschiene wiederum Kabel anzuschließen sind.

Der vorliegenden Erfindung liegt die Aufgabe zugrunde, ein Fassadenelement der eingangs beschriebenen Art in einfacher Weise so weiterzuentwickeln, daß die elektrischen Leitungen direkt aus dem Fassadenelement herausgeführt werden können, wobei der Verlauf dieser Leitungen genau festgelegt ist. Darüber hinaus soll die Isolierwirkung der durch die Energieführung notwendigen Leitungen nicht beeinträchtigt werden.

Die gestellte Aufgabe wird gelöst, in dem zumindest in einem Eckbereich des Fassadenelementes zwischen der als Verbundglasscheibe ausgebildeten Außenscheibe und der Innenscheibe außerhalb des Abstandshalterahmens ein Kabelführungselement vorgesehen ist, welches mit einem Kabelführungskanal versehen ist, der zur lageorientierten Führung des Kabels von der dem Abstandshalterahmen zugewandten Seite zu der dem Abstandshalterahmen abgewandten Seite verläuft.

Durch dieses Kabelführungselement ist sichergestellt, daß zur Entnahme der Energie der Kabelverlauf so festgelegt ist, daß auch das Kabel bei allen Fassadenelementen an der gleichen Stelle austritt. Dies ist vorzugsweise parallel zur Scheibenkante. Das Kabelführungselement hat auch eine Schutzfunktion, damit sichergestellt ist, daß das Kabel nicht beschädigt wird. Da das Kabelführungselement außerhalb des Abstandshalterahmens liegt, wird dieser unverändert belassen, so daß die Isolierwirkung voll erhalten bleibt. Das Fassadenelement liegt in der die Randversiegelung bildenden Siegelmasse, die sich von der Außenseite des Abstandshalterahmens bis zu den äußeren Scheibenrändern erstreckt. Dadurch ist auch gleichzeitig die elektrische Isolierung gegeben. Bei dem Fassadenelement sind die die photovoltarischen Elemente verbindenden Leitungen als Flachband ausgebildet. Im Bereich des Kabelführungselementes ist es ein normales Stromkabel dessen Leiter mit dem Flachband im Eckbereich verbunden ist. Die photovoltarischen Elemente können in einer Reihen- oder Parallelschaltung miteinander verbunden sind. Es kann jedoch auch eine Kombination dieser beiden Schaltungsarten gewählt werden. Im Normalfall ist das Fassadenelement mit zwei Kabelführungselementen ausgerüstet, wobei ein Element dem Pluspol und das andere Element dem Minuspol zugeordnet ist.

In weiterer Ausgestaltung ist vorgesehen, daß das Kabelführungselement winkelförmig ausgebildet ist und der Kabelführungskanal sich über beide Schenkel erstreckt. Diese Ausführung ist besonders konstruktiv einfach, da bei der Herstellung des Fassadenelementes jedes Kabelführungselement mit einem mittleren Steg oder insgesamt in den Raum zwischen der Außenscheibe und der Innenscheibe eingeschoben werden muß.

Da sich der Kabelführungskanal über beide Schenkel erstreckt, erfolgt eine Umlenkung des Kabels um 90°. Dadurch wird bereits eine Zugentlastung der Verbindung, die normalerweise eine Lötstelle ist, zwischen der stromführenden Ader des Kabels und den bandförmigen Leitungen erreicht. Außerdem wird eine ausreichende Länge des Kabelführungskanals erreicht, so daß die Kabelführung auch exakt ist. Dabei ist es dann zweckmäßig, wenn der Kabelführungskanal, bezogen auf die Einbaulage des Fassadenelementes im horizontalen Schenkel an der dem Abstandshalterahmen zugewandten Seite und im vertikalen Schenkel an der dem Abstandsrahmen abgewandten Seite verläuft. In der Einbaulage wird dann das Kabel parallel zu der vertikalen Scheibenkante aus dem Fassadenelement herausgeführt. Das Fassadenelement weist normalerweise eine Randversiegelung auf. Die die Randversiegelung bildende Masse wird in die Räume zwischen den Abstandshalterahmen und den Scheibenrändern eingefüllt. Damit das Kabelführungselement nicht aus der Randversiegelung herausgezogen werden kann, ist vorgesehen, daß das Kabelführungselement an der dem Abstandshalterahmen zugewandten Seite mit Verankerungszungen versehen ist. Diese liegen dann innerhalb der Randversiegelung, so daß ein Formschluß gegeben ist. Obwohl durch die 90° Umlenkung des Kabels bereits eine Zugentlastung der Verbindungsstelle gegeben ist, ist in weiterer Ausgestaltung vorgesehen, daß der Kabelführungskanal zumindest in einem Teilbereich das Kabel form- und/oder kraftschlüssig umgreift. In ein fachster Weise ist dies möglich, wenn das freie Ende des Kabelführungskanals des vertikalen Schenkels umfänglich geschlossen ist, wobei der Innendurchmesser gleich oder ein klein wenig kleiner ist als der Außendurchmesser des Kabels. Es ist jedoch auch noch möglich, daß zur Zugentlastung des Kabels auf dieses im Bereich des freien Endes des Kabelführungskanals des vertikalen Schenkels ein Stützring aufgesetzt ist, der sich bei Zugbelastung des Kabels gegen ein Widerlager des Kabelführungselementes abstützt.
Dieses Widerlager kann auch der umfänglich geschlossene Bereich des freien Endes des Kabelführungskanals des vertikalen Schenkels sein. Durch die Kombination wird dann eine optimale Zugentlastung der Verbindung zwischen der Ader des Kabels und der bandförmigen Leitung erreicht.

Anhand der beiliegenden Zeichnungen, in denen ein bevorzugtes Ausführungsbeispiel dargestellt ist, wird die Erfindung noch näher erläutert.

Es zeigen:
- Figur 1: ein erfindungsgemäßes Fassadenelement rein schematisch in einer Frontansicht,
- Figur 2: eine Ansicht in Richtung der Pfeile II in der Figur 3 gesehen,
- Figur 3: einen Schnitt längs der Linie III-III in der Figur 2.

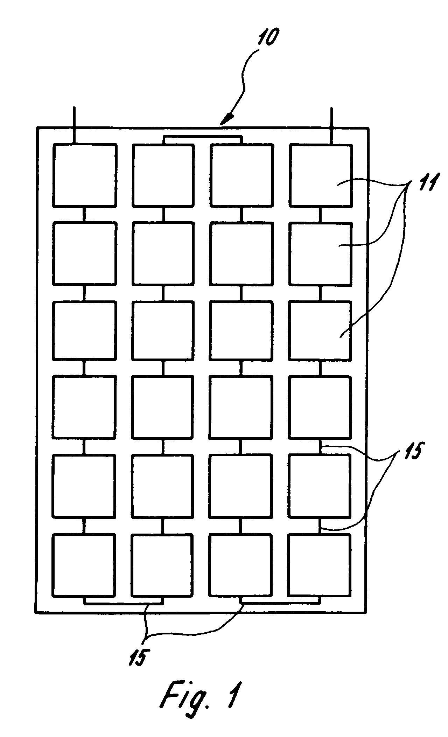

In den Figuren ist das erfindungsgemäße Fassadenelement allgemein durch das Bezugszeichen 10 gekennzeichnet. Durch die Figur 1 soll dargestellt werden, wie die in einer Ebene angeordneten photovoltarischen Elemente 11 in dem Fassadenelement 10 angeordnet sind. Diese Elemente 11 liegen zwischen den beiden Lagen 12, 13 der Verbundglasscheibe, die die Außenscheibe 14 des Fassadenelementes 10 bildet. Die photovoltarischen Elemente 11 sind in mehreren Reihen über die Höhe des Fassadenelementes 10 verteilt und liegen in einem Abstand zueinander. Die elektrische Verbindung erfolgt über Leitungen 15. Die photovoltarischen Elemente sind, bezogen auf die Dicke der Außenscheibe 14 relativ dünn. Die Dicke liegt beispielsweise unter einem Millimeter. In nicht näher dargestellter Weise liegen sie innerhalb einer Gießharzschicht, die zwischen den beiden Lagen 12, 13 der Außenscheibe 14 liegt. Die photovoltarischen Elemente 11 können in einer Reihen- oder Parallelschaltung oder auch in einer Kombination elektrisch leitend miteinander verbunden sein.

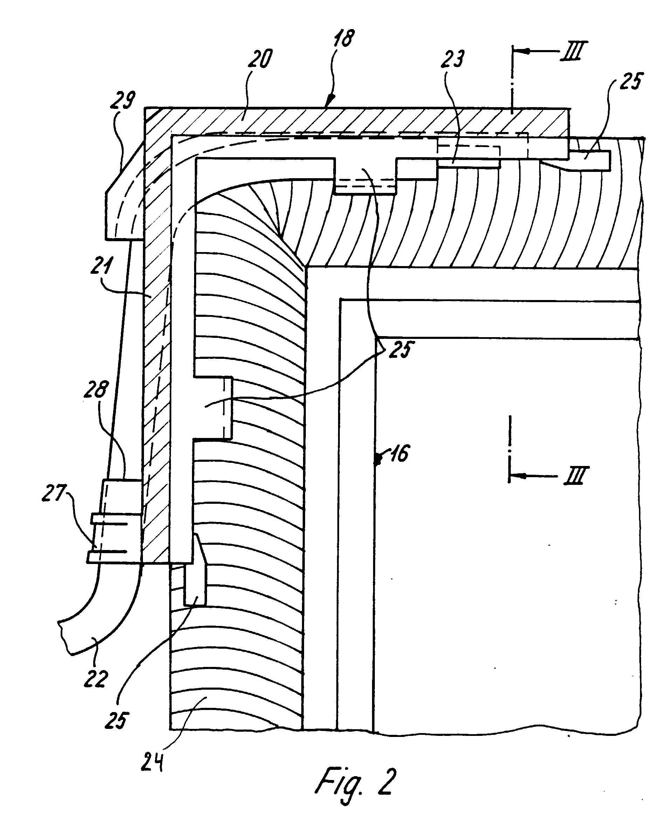

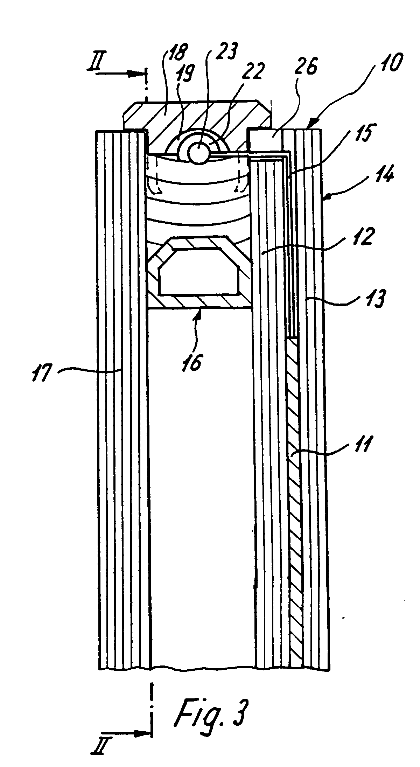

Gemäß der Figur 3 ist die Außenscheibe 14 mittels eines Abstandshalterahmens 16 mit einer Innenscheibe 17 verbunden. Im dargestellten Ausführungsbeispiel ist die Innenscheibe 17 eine einfache Scheibe, d. h., sie besteht aus einer Lage. Sie kann auch aus mehreren Lagen bestehen, wobei die einzelnen Lagen auch im Abstand zueinander angeordnet sein können. Im dargestellten Ausführungsbeispiel steht der obere horizontale Holm des Abstandshalterahmens in einem größeren Abstand zu der Kante des Fassadenelementes 10 als die restlichen Holme. Die Figur 2 zeigt, daß in den oberen linken Eckbereichen ein winkelförmiges Kabelführungselement 18 eingesetzt ist, welches zwischen der inneren Lage 12, der Außenscheibe 14 und der Innenscheibe 17 liegt. Die Randleisten der im Querschnitt T-förmigen Schenkel des Kabelführungselementes 18 stützen sich bei dem Ausführungsbeispiel nach den Fig. 2 und 3 auf den Scheibenkanten ab. Die äußeren Flächen des winkelförmigen Kabelführungselementes 18 können auch bündig zu den jeweiligen Kanten des Fassadenelementes 10 liegen.

Im Querschnitt ist das winkelförmige Kabelführungselement 18 T-förmig ausgebildet, wobei der mittlere Steg relativ kurz ist. Das winkelförmige Kabelführungselement 18 ist mit einem im Querschnitt halbkreisförmig ausgebildeten Kabelführungskanal 19 versehen, der sich im wesentlichen über die Länge des horizontalen Schenkels 20 und des vertikalen Schenkels 21 erstreckt. Durch den Kabelführungskanal 19 ist ein Kabel 22 gezogen. Die Ader des Kabels 22 ist im Endbereich des horizontalen Schenkels 20 freigelegt, so daß in nicht näher dargestellter Weise die Verbindung mit dem Ende der bandförmigen Leitung 15 beispielsweise durch Löten hergestellt werden kann. Diese Ader ist durch das Bezugszeichen 23 gekennzeichnet. Aus der Figur 2 ergibt sich, daß sich der Kabelführungskanal von der dem Abstandshalterahmen 16 zugewandten Seite des horizontalen Schenkels 20 zu der dem Abstandshalterahmen 16 abgewandten Seite des vertikalen Schenkels 21 erstreckt, so daß das Kabel 22 parallel zur vertikalen Kante des Fassadenelementes 10 geführt werden kann. Der außerhalb des Abstandshalterahmens 16 und den Scheibenrändern liegende Raum ist zur Bildung der üblichen Randversiegelung 24 mit einer Siegelmasse ausgespritzt. Dadurch ist auch der Bereich zwischen dem winkelförmigen Kabelführungselement 18 und dem Abstandshalterahmen 16 mit dieser Masse ausgefüllt. Damit das Kabelführungselement 18 formschlüssig gehalten ist, sind daran mehrere Verankerungszungen 25 angeformt. Im dargestellten Ausführungsbeispiel sind sie an den beiden Stirnenden und im mittleren Bereich des horizontalen Schenkels 20 und des vertikalen Schenkels 21 angeformt.

Aus der Figur 3 geht außerdem noch die Führung der Leitungen 15 aus der Außenscheibe 14 hervor. Die innere Lage 12 der Außenscheibe 14 ist im Bereich des freien Endes des horizontalen Schenkels 20 des winkelförmigen Kabelführungselementes 18 mit einer Aussparung 26 versehen, durch die die Leitung 15 geführt ist. Im Gegensatz dazu ist es auch möglich, in diesem Bereich eine Bohrung einzuarbeiten. Aus der Figur 2 ergibt sich, daß durch die 90° Umlenkung des Kabels 22 bereits eine Zugentlastung für den Verbindungsbereich zwischen der Ader 13 und der Leitung 15 erfolgt. Zusätzlich ist der Endbereich des vertikalen Schenkels 21 des winkelförmigen Kabelführungselementes 18 umfänglich geschlossen, d. h. dieser Bereich hat eine Bohrung, die so ausgelegt ist, daß das Kabel 22 umschlossen ist. Diese Bohrung kann ein klein wenig kleiner sein als der Außendurchmesser des Kabels 22, so daß zum Bewegen des Kabels 22 Kräfte notwendig sind. Dieser Bereich ist durch das Bezugszeichen 27 gekennzeichnet. Dieser Bereich kann auch in Form einer Schelle ausgebildet sein, so daß auf das Kabel Radialkräfte einwirken. Auf das Kabel 22 ist außerdem ein Stützring 28 aufgesetzt, der gegen den ein Widerlager bildenden Bereich 27 abstützt. Der Stützring 28 liegt dem Scheitelpunkt des winkelförmigen Kabelführungselementes 18 zugewandt. Dadurch wird eine optimale Zugentlastung erreicht.

Das winkelförmige Kabelführungselement 18 ist ein Kunststofformteil. Im Bereich seines Scheitelpunktes ist an der dem Abstandshalterahmen 16 abgewandten Seite ein Übergangsstück 29 angeformt. In diesem Bereich ist der Kabelführungskanal 19 im Querschnitt kreisförmig, so daß die Um lenkung des Kabels unterstützt wird.

## Patentansprüche

1. Fassadenelement, mit einer als Verbundglasscheibe ausgebildeten Außenscheibe (14) und mit einer aus mindestens einer Glasscheibe bestehenden Innenscheibe (17), die über einen Abstandshalterahmen (16) mit der Außenscheibe verbunden ist, wobei zwischen den Lagen der Außenscheibe im Abstand zueinander angeordnete photovoltarische Elemente (11) angeordnet sind, die über elektrische Leitungen (15) miteinander verbunden sind, **dadurch gekennzeichnet**, daß zumindest in einem Eckbereich des Fassadenelementes (10) zwischen der als Verbundglasscheibe ausgebildeten Außenscheibe (14) und der Innenscheibe (17) außerhalb des Abstandshalterahmens (16) ein Kabelführungselement (18) vorgesehen ist, welches mit einem Kabelführungskanal (19) versehen ist, der zur lageorientierten Führung des Kabels (22) von der dem standshalterahmen (16) zugewandten Seite zu der dem standshalterahmen (16) abgewandten Seite verläuft.

2. Fassadenelement nach Anspruch 1, dadurch gekennzeichnet, daß das Kabelführungselement (18) winkelförmig ausgebildet ist und der Kabelführungskanal (19) sich über beide Schenkel erstreckt.

3. Fassadenelement nach Anspruch 1, dadurch gekennzeichnet, daß der Kabelführungskanal (19), bezogen auf die Einbaulage des Fassadenelementes (10) im horizontalen Schenkel an der dem Abstandshalterahmen (16) zugewandten Seite und dem vertikalen Schenkel an der dem standshalterahmen (16) abgewandten Seite verläuft.

4. Fassadenelement nach Anspruch 3, dadurch gekennzeichnet, daß der Kabelführungskanal (19) zur Zugentlastung des Kabels (22) zumindest in einem Teilbereich des Kabelführungskanals (19) das Kabel (22) form- und/oder kraftschlüssig umgreift.

5. Fassadenelement nach Anspruch 4, dadurch gekennzeichnet, daß der freie Endbereich des führungskanals (19) des vertikalen Schenkels des führungselementes (18) umfänglich geschlossen ist, wobei der Innendurchmesser gleich oder ein klein wenig kleiner ist als der Außendurchmesser des Kabels (22).

6. Fassadenelement nach einem oder mehreren der vorhergehenden Ansprüche, dadurch gekennzeichnet, daß zur Zugentlastung des Kabels (22) auf dieses im Bereich des freien Endes des Kabelführungskanales (19) des vertikalen Schenkels ein Stützring (28) aufgesetzt ist, der sich bei Zugbelastung des Kabels (22) gegen ein Widerlager des Kabelführungselementes (18) abstützt.

7. Fassadenelement nach Anspruch 6, dadurch gekennzeichnet, daß das Widerlager (27) der geschlossene Endbereich des Kabelführungskanals (19) der vertikalen Schenkels des Kabelführungselementes (18) ist.

8. Fassadenelement nach einem oder mehreren der vorhergehenden Ansprüche, dadurch gekennzeichnet, daß der Kabelführungskanal (19) im Querschnitt halbkreisförmig gestaltet ist.

9. Fassadenelement nach einem oder mehreren der vorhergehenden Ansprüche, dadurch gekennzeichnet, daß das winkelförmige Kabelführungselement (18) zumindest an der dem Abstandshalterahmen (16) zugewandten Seite mit Verankerungszungen (25) versehen ist.

10. Fassadenelememtes nach Anspruch 9, dadurch gekennzeichnet, daß auch in den Stirnendbereichen der beiden Schenkel des winkelförmigen Kabelführungselementes (18) Verankerungszungen (25) angeformt sind.

11. Fassadenelement nach Anspruch 2, dadurch gekennzeichnet, daß die Schenkel des winkelförmigen Kabelführungselementes im Querschnitt T-förmig ausgebildet sind.

12. Fassadenelement nach Anspruch 11, dadurch gekennzeichnet, daß die Randleisten der Schenkel des Kabelführungselementes sich auf den Scheibenkanten abstützen.

## Claims

1. A facade element comprising an outer pane (14) in the form of a composite glass pane and an inner pane (17) which comprises at least one glass pane and which is connected to the outer pane by way of a spacer frame (16), wherein arranged between the layers of the outer pane and disposed at spacings relative to each other are photovoltaic elements (11) which are connected together by way of electric lines (15), characterised in that at least in a corner region of the facade element (10) between the outer pane (14) which is in the form of a composite glass pane and the inner pane (17) outside the spacer frame (16) there is a cable guide element (18) provided with a cable guide passage (19) which for positionally oriented guidance of the cable (22) extends from the side which is towards the spacer frame (16) to the side which is remote from the spacer frame (16).

2. A facade element according to claim 1 characterised in that the cable guide element (18) is of an angular configuration and the cable guide passage (19) extends over both limbs.

3. A facade element according to claim 1 characterised in that the cable guide passage (19), with respect to the position of installation of the facade element (10), extends in the horizontal limb at the side which is towards the spacer frame (16) and the vertical limb at the side which is remote from the spacer frame (16).

4. A facade element according to claim 3 characterised in that the cable guide passage (19) embraces the cable (22) in positively locking engagement and/or force-locking engagement to relieve the tensile load on the cable (22), at least in a portion of the cable guide passage (19).

5. A facade element according to claim 4 characterised in that the free end region of the cable guide passage (19) of the vertical limb of the cable guide element (18) is peripherally closed, the inside diameter being the same as or a little less than the outside diameter of the cable (22).

6. A facade element according to one or more of the preceding claims characterised in that to relieve the tensile load on the cable (22) a support ring (28) is fitted on to same in the region of the free end of the cable guide passage (19) of the vertical limb, the support ring (28) bearing against a support means of the cable guide element (18) when the cable (22) is subjected to a tensile loading.

7. A facade element according to claim 6 characterised in that the support means (27) is the closed end region of the cable guide passage (19) of the vertical limb of the cable guide element (18).

8. A facade element according to one or more of the preceding claims characterised in that the cable guide passage (19) is of a semicircular cross-sectional configuration.

9. A facade element according to one or more of the preceding claims characterised in that the angular cable guide element (18) is provided with anchoring tongues (25) at least at the side which is towards the spacer frame (16).

10. A facade element according to claim 9 characterised in that anchoring tongues (25) are also formed in the end regions of the two limbs of the angular cable guide element (18).

11. A facade element according to claim 2 characterised in that the limbs of the angular cable guide element are of a T-shaped cross-sectional configuration.

12. A facade element according to claim 11 characterised in that the edge strips of the limbs of the cable guide element are supported on the pane edges.

## Revendications

1. Elément de façade, avec une vitre extérieure (14) réalisée comme une vitre en verre feuilleté et avec une vitre intérieure (17) comprenant au moins une vitre en verre, qui est reliée par un cadre écarteur (16) à la vitre extérieure, des éléments photovoltaïques (11) espacés les uns des autres étant disposés entre les couches de la vitre extérieure, lesquels éléments sont reliés entre eux par des lignes électriques (15), caractérisé en ce qu'au moins dans une zone d'angle de l'élément de façade (10), entre la vitre extérieure (14) réalisée comme une vitre en verre feuilleté et la vitre intérieure (17) il est prévu à l'extérieur du cadre écarteur (16) un élément de guidage de câble (18) qui est pourvu d'un canal de guidage de câble (19) qui, pour le guidage orienté en position du câble (22), va du côté tourné vers le cadre écarteur (16) jusqu'au côté opposé au cadre écarteur (16).

2. Elément de façade selon la revendication 1, caractérisé en ce que l'élément de guidage de câble (18) est réalisé avec une forme angulaire et le canal de guidage de câble (19) s'étend sur ses deux branches.

3. Elément de façade selon la revendication 1, caractérisé en ce que le canal de guidage de câble (19) s'étend, par rapport à la position de montage de l'élément de façade (10), dans la branche horizontale du côté tourné vers le cadre écarteur (16) et dans la branche verticale du côté opposé au cadre écarteur (16).

4. Elément de façade selon la revendication 3, caractérisé en ce que le canal de guidage de câble (19) entoure le câble (22) mécaniquement et/ou par adhérence pour le soulagement en traction du câble (22) au moins dans une zone partielle du canal de guidage de câble (19).

5. Elément de façade selon la revendication 4, caractérisé en ce que la zone d'extrémité libre du canal de guidage de câble (19) de la branche verticale de l'élément de guidage de câble (18) est fermée à sa périphérie, le diamètre intérieur de cet endroit étant égal ou légèrement inférieur au diamètre extérieur du câble (22).

6. Elément de façade selon l'une ou plusieurs des revendications précédentes, caractérisé en ce que, pour le soulagement en traction du câble (22), il est posé sur celui-ci dans la zone de l'extrémité libre du canal de guidage de câble (19) de la branche verticale une bague de soutien (28) qui s'appuie contre une butée de l'élément de guidage de câble (18) pour le soulagement en traction de câble (22).

7. Elément de façade selon la revendication 6, caractérisé en ce que la butée (27) est la zone d'extrémité fermée du canal de guidage de câble (19) de la branche verticale de l'élément de guidage de câble (18).

8. Elément de façade selon l'une ou plusieurs des revendications précédentes, caractérisé en ce que le canal de guidage de câble (19) est d'allure semi-circulaire en section.

9. Elément de façade selon l'une ou plusieurs de revendications précédentes, caractérisé en ce que l'élément de guidage de câble (18) de forme angulaire est pourvu de lames d'ancrage (25) au moins du côté tourné vers le cadre écarteur (16).

10. Elément de façade selon la revendication 9, caractérisé en ce que des lames d'ancrage (25) sont formées également dans les zones d'extrémité frontales des deux branches de l'élément de guidage de câble (18) de forme angulaire.

11. Elément de façade selon la revendication 2, caractérisé en ce que les branches de l'élément de guidage de câble de forme angulaire sont conformées avec une section en forme de T.

12. Elément de façade selon la revendication 11, caractérisé en ce que les baguettes de bordure des branches de l'élément de guidage de câble s'appuient sur les bords des vitres.
